# EUROPEAN PATENT SPECIFICATION

(11) **EP 0 530 834 B1**
(45) Date of publication and mention of the grant of the patent: **04.12.1996**
(21) Application number: 92115193.2
(22) Date of filing: 04.09.1992
(51) Int. Cl.: G02F 1/136, H01L 29/772, H01L 21/336

(54) **Thin-film transistor and method of manufacturing the same**
Dünnschichttransistor und dessen Herstellungsmethode
Transistor à couches minces et sa méthode de fabrication

(30) Priority: 05.09.1991 JP 252845/91; 13.12.1991 JP 351329/91
(43) Date of publication of application: 10.03.1993
(73) Proprietor: CASIO COMPUTER COMPANY LIMITED, Shinjuku-ku Tokyo 160 (JP)
(72) Inventor: Matsuda, Kunihiro, c/o Patent Dep., Hamura R & D, Hamura-shi, Tokyo 190-11 (JP)
(74) Representative: Grünecker, Kinkeldey, Stockmair & Schwanhäusser Anwaltssozietät

(56) References cited:
- EP-A- 0 329 274
- EP-A- 0 361 609
- PATENT ABSTRACTS OF JAPAN vol. 10, no. 367 (E-462)(2424) 9 December 1986 & JP-A-61 164 267
- PATENT ABSTRACTS OF JAPAN vol. 10, no. 255 (E-433)2 September 1986 & JP-A-61 084 057

## Description

The present invention relates to a thin-film transistor panel and a method of manufacturing same according to the preamble parts of claims 1 and 6.

Such a thin-film transistor panel is known for example from JP-A-61164267.

Known as a thin-film transistor for use as, for example, one of the active elements of an active matrix liquid-crystal display is one having an inverse stagger structure. The thin-film transistor of this type comprises a substrate, a gate electrode formed on the substrate, a gate-insulating film formed on the gate electrode, an i-type semiconductor layer formed on the gate-insulating film, an n-type semiconductor layer formed on the i-type semiconductor layer, a source electrode formed on one end portion of the n-type semiconductor layer, a drain electrode formed on the other end portion of the n-type semiconductor layer.

The method which is commonly employed to manufacture a thin-film transistor having the inverse stagger structure will be described, with reference to Figs. 9A to 9E.

Figs. 9A to 9E are cross-sectional views explaining the method of manufacturing the conventional thin-film transistor, which is formed on one of the transparent substrates of an active matrix liquid-crystal display and used as an active element for a pixel electrode.

### [Step 1]

First, as is shown in Fig. 9A, a gate electrode 2G is formed on a transparent substrate 1 made of insulative material such as glass. Next, a wiring or a scanning line (not shown) is formed on the substrate 1, which is connected to the the gate electrode 2G. A gate-insulating film 3 is formed on the substrate 1, the gate electrode 2G and the scanning line. Further, an i-type semiconductor layer 4 is formed on the gate-insulating film 3, and a blocking insulation layer 7 is formed on the i-type semiconductor layer 4, protecting the layer 4.

The gate electrode 2G and the scanning line (not shown) are formed by depositing Ta, Ta-Mo alloy, Cr, or the like on the substrate 1 by means of sputtering or plating, and then by patterning the resultant metal layer by means of photolithography.

In most cases, the gate-insulating film 3 is made of SiN (silicon nitride) or the like, the i-type semiconductor layer 4 is made of a-Si (amorphous silicon), and the blocking insulation layer 7 is made of the same insulative material (SiN or the like) as the gate-insulating film 3. The film 3, the layer 4, and the layer 7 are continuously formed by plasma CVD method.

### [Step 2]

Next, as is shown in Figs. 9B, the blocking insulation layer 7 is patterned by photolithography, to be substantially the same size and shape as that portion of the i-type semiconductor layer 4 which will be a channel region. The i-type semiconductor layer 4 is patterned by Photolithography, forming a layer which has a specific shape.

### [Step 3]

As is shown in Fig. 9C, an n-type semiconductor layer 5 is formed by plasma CVD method on the substrate 1, covering the i-type semiconductor layer 4 and the insulation layer 7. A metal film 6, which will be processed to be a source electrode and a drain electrode, is formed on the n-type semiconductor layer 5 by means of sputtering. The n-type semiconductor layer 5 is made of a-Si doped with an impurity, and the metal film 6 is made of Cr or the like.

### [Step 4]

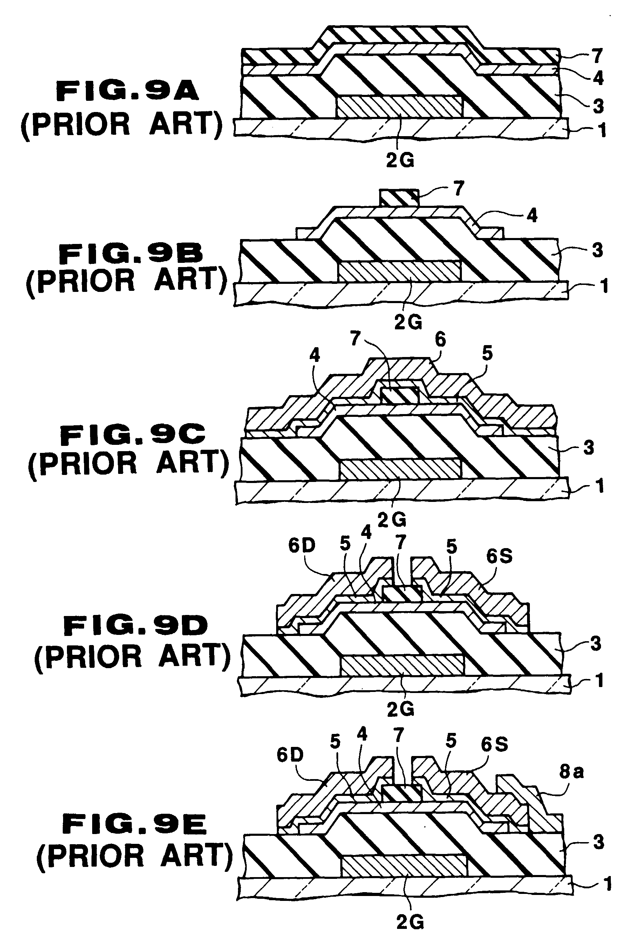

Then, as is shown in Fig. 9D, the metal film 6 is patterned by photolithography, forming a source electrode 6S, a drain electrode 6D, and a wiring or a data line (not shown) connected to the drain electrode 6D. Further, the n-type semiconductor layer 5 is etched away, except for those portions which are located beneath the source electrode 6S and the drain electrode 6D to separate the layer 5 at the the channel region. As a result, a thin-film transistor is manufactured.

If the n-type semiconductor layer 5 contacts the channel region of the i-type semiconductor layer 4 at the time etching the n-type semiconductor layer 5, the surface of the channel region of the i-type semiconductor layer 4 will also be etched, inevitably damaging the i-type semiconductor layer 4 and degrading the characteristics of the thin-film transistor. In the method described above, the blocking insulation layer 7 is formed on the channel region of the i-type semiconductor layer 4, and the i-type semiconductor layer 4 is therefore prevented from being etched when the n-type semiconductor layer 5 is etched. Hence it is possible to manufacture a thin-film transistor which has good characteristics.

Fig. 9E shows the thin-film transistor thus manufactured and provided with a pixel electrode 8a which is formed on the gate-insulating film 3. The pixel electrode 8a has been by patterning a transparent conductive film made of ITO or the like. The electrode 8a has its one end portion laid on the source electrode 6S, and is thereby electrically connected to the source electrode 6S.

In the prior-art method of manufacturing a thin-film transistor, which has been described above, selective etching is performed on the n-type semiconductor layer 5, thereby removing that portion of this layer 5 which is located above the channel region of the i-type semiconductor layer 4. It is therefore necessary to prevent the i-type semiconductor layer 4 from being etched during the selective etching of the layer 5, so that the i-type semiconductor layer 4 may not be damaged. To this end, the blocking insulation film 7 must be formed on the channel region of the i-type semiconductor layer 4.

Hence, it is required that the blocking insulation layer 7 be patterned by photolithography, before the n-type semiconductor layer 5 and the metal film 6 are formed. The method inevitably have a large number of steps. This means that the conufacturing cost of the film-film transistor is high if the transistor is made by the conventional method.

To make matter worse, since the blocking insulation layer 7 is made of, as in most cases, the same insulative material (e.g., SiN) as the gate-insulating film 3, the etching solution applied for patterning the layer 7 flows via pinholes made, if any, in the i-type semiconductor layer 4, and reaches the gate-insulating film 3. Thus, the gate-insulating film 3 is eniviably etched, too. Due to such undesired etching of the film 3 which has occurred during the patterning of the blocking insulation layer 7, the gate-insulating film 3 has pin holes. It is through these pin holes that the gate electrode 2G, the source electrode 6S, and the drain electrode 6D are short-circuited.

According to conventional TFTs, the connection terminals of the gate and drain lines are formed of metal and are exposed to the atmospheric air. Therefore the surface regions of the connection terminals are oxidized during the manufacturing process and its usage by oxygen and humidity in the atmosphere. As a consequence thereof, the connection terminals are covered by an insulation oxidation film during the manufacturing process and its usage, thereby resulting in a low reliability.

Accordingly, the object of the present invention is to provide a thin film transistor having a high reliability.

This object is solved by a thin film transistor panel having the features of claim 1 and by a manufacturing method having the steps as set forth in claim 6.

Preferred embodiments are subjects of various dependent claims.

This invention can be more fully understood from the following detailed description when taken in conjunction with the accompanying drawings, in which:
Fig. 1 is a plan view showing a thin-film transistor array according to a first embodiment of the present invention;
Digs. 2A to 2D are cross-sectional views explaining a method of manufacturing a thin-film transistor;
Fig. 3 is a plan view showing a thin-film transistor panel which incorporates the thin-film transistor shown in Figs. 2A to 2D, and which is a second embodiment of the invention;
Figs. 4 to 6 are cross-sectional views of the thin-film transistor panel, taken along line IV-IV, line V-V, and line VI-VI shown in Fig. 3, respectively;
Figs. 7A to 7D are cross-sectional views explaining how to manufacture the thin-film transistor incorporated in the panel shown in Figs. 4 to 6, and Figs. 8A to 8D are cross-sectional views explaining how to manufacture the thin-film transistor panel; and
Figs. 9A to 9E are cross-sectional view explaining a method of manufacturing a conventional thin-film transistor.

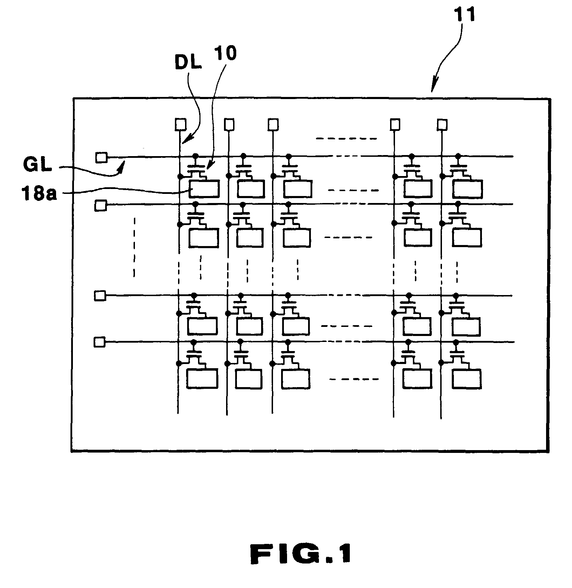

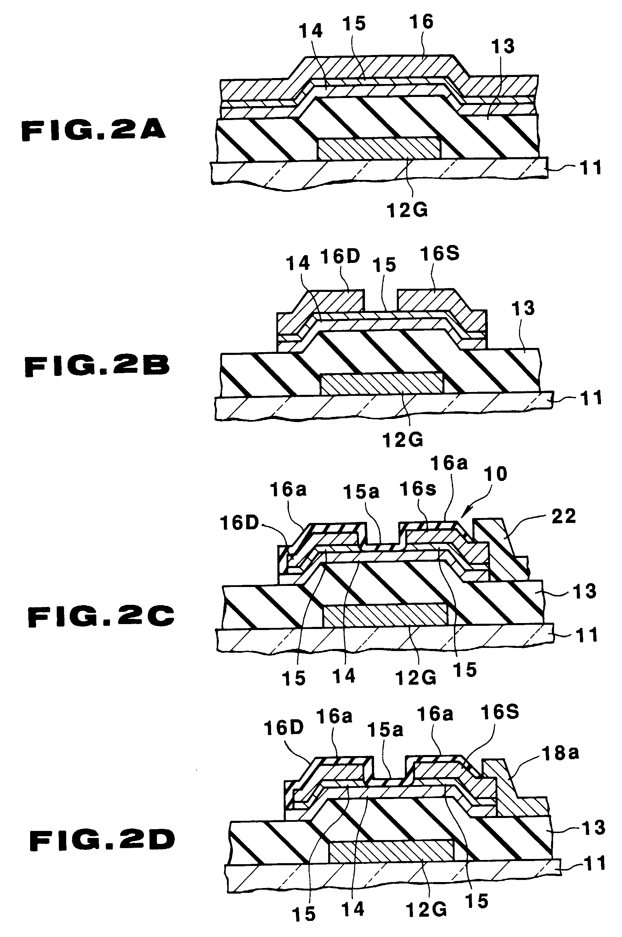

A thin-film transistor formed on one of the transparent substrates of an active matrix liquid-crystal display and designed for use as the active element for a pixel electrode, and an array of thin-film transistors of this type (i.e., a TFT array), both being a first embodiment of the present invention, will be described with reference to Fig. 1 and Figs. 2A to 2D.

Fig. 1 is a schematic plan view of the TFT array. As is shown in this figure, the TFT array comprises a substrate 11, a plurality of scanning lines GL formed on the substrate 11 and extending parallel to one another, a plurality of data lines DD extending parallel to one another and at right angles to the scanning lines GL, a plurality of TFT elements 10 arranged in rows and columns, each having its gate electrode connected to one of the scanning line and its drain connected to one of the data lines DL, and a plurality of pixel electrodes 18a arranged in rows and columns and connected to the TFTs, respectively, thus forming a display region.

Each TFT element 10 and each pixel electrode 18a, which are located at the intersection of a scanning line GL and a data line DL, will now be described with reference to Fig. 2D. As is shown in Fig. 2D, the TFT element 10 comprises a gate electrode 12G, a gate-insulating film 13 covering the gate electrode 12G, an i-type semiconductor layer 14 of amorphous silicon formed on that portion of the film 13 which is located above the electrode 12G, an n-type semiconductor layer 15 formed on the i-type layer 14, a drain electrode 16D formed on that portion of the n-type layer 15 which is located on one end portion of the i-type layer 14, and a source electrode 16S formed on that portion of the n-type layer 15 which is located on the other end portion of the i-type layer 14. The gate electrode 12G is integral with one of the scanning lines GL formed on the substrate 11. The drain electrode 16D is connected to an data line DL, and the source electrode 16S is connected to one of the pixel electrodes 18a which are made of transparent conductive film. The i-type semiconductor layer 14 has a channel region which has been anodically oxidized and, thus, functions as an insulative film 15a.

It will now be explained how the TFT 10 is manufactured, with reference to Figs. 2A to 2D.

### [Step 1]

First, as is shown in Fig. 2A, a gate electrode 12 is formed on a transparent substrate 11 made of insulative material such as glass. Next, a scanning line GL is formed on the substrate 1, which is connected to the the gate electrode 12. A gate-insulating film 13 made of SiN or the like is formed by plasma CVD method on the substrate 11, the gate electrode 12 and the scanning line. Further, an i-type semiconductor layer 14 made of a-Si is formed on the gate-insulating film 13 by means of plasma CVD method. Then, an n-type semiconductor layer 15 made of a-Si doped with an n-type impurity is formed on the i-type semiconductor layer 14 by means of plasma CVD method. Further, a metal film 16 made of metal such as Cr, which will be processed to be a source electrode and a drain electrode, is formed on the n-type semiconductor layer 15 by means of sputtering.

The n-type semiconductor layer 15 is about 25 to 100 nm thick, whereas the metal film 16 is about 200 to 500 nm thick. The gate electrode 12 and the scanning line GL are formed by depositing Ta, Ta-Mo alloy, Cr, Aℓ, Aℓ-Ti alloy or the like on the substrate 11 by means of sputtering or plating, and then by patterning the resultant metal layer by means of photolithography.

### [Step 2]

Next, as is shown in Fig. 2B, the metal film 16 is patterned by photolithography, forming a source electrode 16S a drain electrode 16D, and a data line DL connected to the drain electrode 16D. Thereafter, the n-type semiconductor layer 15 is etched away, except for the those portions located beneath the electrodes 16S and 16D and that portion extending between these electrodes 16S and 16D. Also, the i-type semiconductor layer 14 is etched away, except for those portions which are located beneath the electrodes 16S and 16D and that portion which will be a channel region.

This selective etching of the layers 14 and 15 is accomplished by by using both the source electrode 16S and the drain electrode 16D as etching masks, and by forming a resist mask (not shown) on those portions of the n-type layer 15 which are located beneath the source electrode 16S and the drain electrode 16D and on that portion of the layer 15 which extends between the electrodes 16S and 16D.

### [Step 3]

The resist mask is removed from the n-type semiconductor layer 15. Then, as is shown in Fig. 2C, that portion of the n-type semiconductor layer 15, which extends between the electrodes 16S and 16D and is located on that portion of the i-type semiconductor layer 14 which will be the channel region, is oxidized anodically in its entirety thickness direction. This portion of the layer 15, thus oxidized, electrically cuts the n-type semiconductor layer 15 into two parts. Thus, a thin-film transistor 10 is manufactured.

More specifically, the portion of the n-type semiconductor layer 15 is anodically oxidized in the following way. First, the wiring (hereinafter referred as a data line) extending from the drain electrode 16D is connected to the anode of an DC power supply by a clip-type connector. The unfinished product is immersed in a bath of an electrolytic solution (e.g., solution of ammonium borate), except for that end of the data line which is connected to the DC power supply. In the solution bath, the unfinished product is so positioned that the drain electrode 16D opposes an opposite electrode (cathode) placed in the solution bath. In this condition, an electric current is supplied to the n-type semiconductor layer 15 through the data line and the drain electrode 16D. A voltage is thereby applied between the layer 15 and the cathode, achieving the anodic oxidation of the n-type semiconductor layer 15. During this anodic oxidation, that portion of the source electrode 16S is kept covered with a resist mask 22.

When the voltage is applied between the n-type semiconductor layer 15 and the cathode, that portion of the layer 15 acting as anode which is immersed in the electrolytic solution (i.e., the portion extending between the source electrode 16S and the drain electrode 16D) undergoes a chemical reaction and is gradually oxidized from its surface. Upon lapse of a predetermined time, said portion of the n-type semiconductor layer 15 changes into an oxidized insulative layer 15a. The layer 15a electrically cuts the n-type semiconductor layer 15 into two parts.

Once anodically oxidized in its entirety thickness direction as described above, that portion of the n-type semiconductor layer 15 which extends between the electrodes 16S and 16D becomes electrically insulative, whereby the n-type semiconductor layer 15 is electrically cut into two parts.

As the n-type semiconductor layer 15 is anodically oxidized gradually from its exposed surface, whereby the oxidized insulation layer 15a grows thicker, said portion of the layer 15 becomes thinner. Nonetheless, the electric current keeps flowing through the n-type semiconductor layer 15 until the insulation layer 15a grows to reach the surface of the i-type semiconductor layer 14. Hence, that portion of the layer 15 can be anodically oxidized in its entirety thickness direction when the current stops flowing through it, only if the voltage applied is relatively high (for example, about 50V in the case where the layer 15 is 25 nm thick). Thus, that portion of the layer 15 which extends between the electrodes 16S and 16D is oxidized in its entirety. In other words, it is oxidized until the current stops flowing at the interface between the i-type semiconductor layer 14 and the n-type semiconductor layer 15. As a result, the n-type semiconductor layer 15 is electrically cut into two parts, at the position above that portion of the i-type semiconductor layer 14 which functions as a channel region.

In this embodiment, the anodic oxidation of said portion of the layer 15 is carried out by supplying an electric current to the n-type semiconductor layer 15 through the data line and the drain electrode 16D. Hence, the surfaces of the data line and the drain electrode 16D also undergo chemical reaction in the electrolytic solution bath and are oxidized anodically. In addition, since the electric current is supplied to the source electrode 16S, too, through the n-type semiconductor layer 15, the source electrode 16S is also anodically oxidized at its upper surface. As a result, as is shown in Fig. 2C, the surfaces of the source electrode 16S and the drain electrode 16D form two oxidized insulation layers 16a. These insulation layers 16a protect the source electrode 16S and the drain electrode 16D, respectively.

Any metal is oxidized faster than any n-type semiconductor under the same condition. Therefore, the oxidized insulation layers 16a grows somewhat thicker than the n-type semiconductor layer 15, while said portion of the layer 15 is being oxidized in its entirety thickness direction. The insulation layer 16a on the source electrode 16S is thinner than the insulation layer 16a formed on the drain electrode 16D for two reasons. First, the voltage applied on the source electrode 16S is one dropped in the n-type semiconductor layer 15. Secondly, no voltage is applied to the source electrode 16S once the n-type semiconductor layer 15 has been electrically cut into to parts.

Although the oxidized insulation layers 16a are somewhat thicker than the n-type semiconductor layer 15, both the source electrode 16S and the drain electrode 16D remain thick enough to attain sufficient conductivity. This is because, as has been pointed out, these electrodes 16S and 16D have a thickness of about 200 to 500 nm, far greater that the thickness (i.e., about 25 to 100 nm) of the n-type semiconductor layer 15 before their surfaces are oxidized anodically.

The thin-film transistor, thus manufactured, is used as one of active elements of an active matrix liquid-crystal display. Therefore, its source electrode 16S needs to be electrically connected at an end to a pixel electrode. The end portion of the source electrode 16S will not be electrically connected to the pixel electrode if the surface of this end portion is oxidized anodically. To prevent such an electrical disconnection, the end portion of the electrode 16S is covered with a resist mask 22 as is shown in Fig. 2C before the anodic oxidation is carried out. Since the mask 22 protects the end portion of the electrode 16S from the electrolytic solution, the end portion of the electrode 16S is electrically connected to the pixel electrode, achieving good conduction between the the source electrode 16S and the pixel electrode.

As is shown in Fig. 2D, a pixel electrode 18a is formed on a portion of the gate-insulating film 13. The pixel electrode 18a has a portion formed on one portion of the source electrode 16S of the thin-film transistor. The electrode 18a is made by removing the resist mask 22 from the end portion of the electrode 16S, forming a transparent conductive film made of ITO or the like on the end portion of the electrode 16S, and patterning the conductive film thus formed.

In the method of manufacturing a thin-film transistor, described above, the n-type semiconductor layer 15 is electrically cut at the portion located above the channel region of the transistor, not by means of etching but by means of anodic oxidation. More precisely, that portion of the layer 15 becomes electrically insulative when it is anodically oxidized in its entirety thickness direction, whereby the n-type semiconductor layer 15 is electrically cut into two parts.

Since the n-type semiconductor layer 15 is electrically divided into two parts not by etching, a blocking insulation film need not be formed on the channel region of the i-type semiconductor layer 14 as in the prior-art method. Hence, no damages are done to the i-type semiconductor layer 14 during the manufacture of the thin-film transistor. Without a step of forming a blocking insulation film, the method of the present invention helps to reduce the cost of manufacturing thin-film transistors.

Since no blocking insulation film needs to be formed in the method described above, pinholes are not formed in a gate-insulating film as in the conventional method of manufacturing a thin-film transistor. Thus there is no possibility that the gate electrode 12 is short-circuited with the source electrode 16S or the drain electrode 16D. With this method it is therefore possible to enhance the yield of thin-film transistors.

In the first embodiment, the surface of the source electrode 16S and that of the drain electrode 16D are oxidized at the time of anodically oxidizing the selected portion of the n-type semiconductor layer 15. Instead, only that portion of the layer 15 can be anodically oxidized, with both the source electrode 16S and the drain electrode 16D covered with resist masks.

The method described above, which is the first embodiment of the invention is one for manufacturing a thin-film transistor which is formed on one of the two transparent substrates of an active matrix liquid-crystal display and which is designed as the active element for a pixel electrode. Nonetheless, the method can be used to manufacture a thin-film transistor for any other purpose.

As has been described, in the method the n-type semiconductor layer is electrically divided into two parts at the portion located above the channel region of the thin-film transistor, not by means of etching but by anodic oxidation. Thus, no damages are done to the i-type semiconductor layer located beneath the n-type semiconductor layer. The method, therefore, has no step of forming a blocking insulation layer, making it possible to manufacture the thin-film transistor at low cost. In addition, there is no possibility that pinholes are formed in the gate-insulating film to cause short-circuiting of the gate electrode, the source electrode or the drain electrode, making it possible to enhance the yield of thin-film transistors.

The advantages pointed out in the preceding paragraph, can be attained by the other methods to be described below.

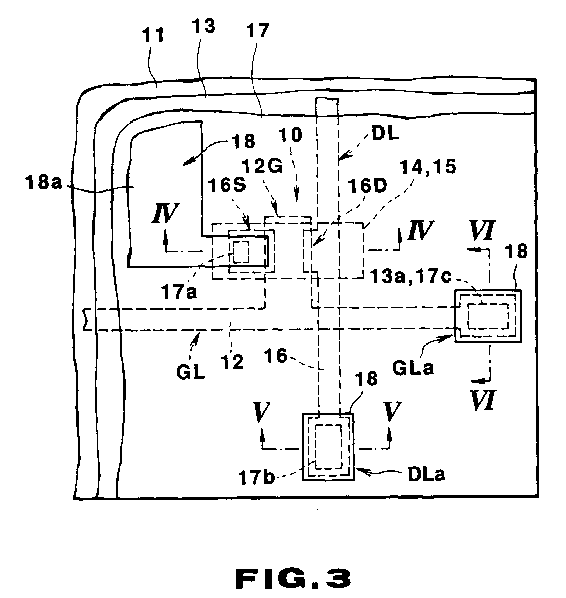

The thin-film transistor according to the invention, and the method of manufacturing this invention will be described, with reference to Figs. 3 to 7 and Figs. 8A to 8D. The components which are identical or similar to those shown in Figs. 2A to 2D will be designated at the same reference numerals and will not be described in detail.

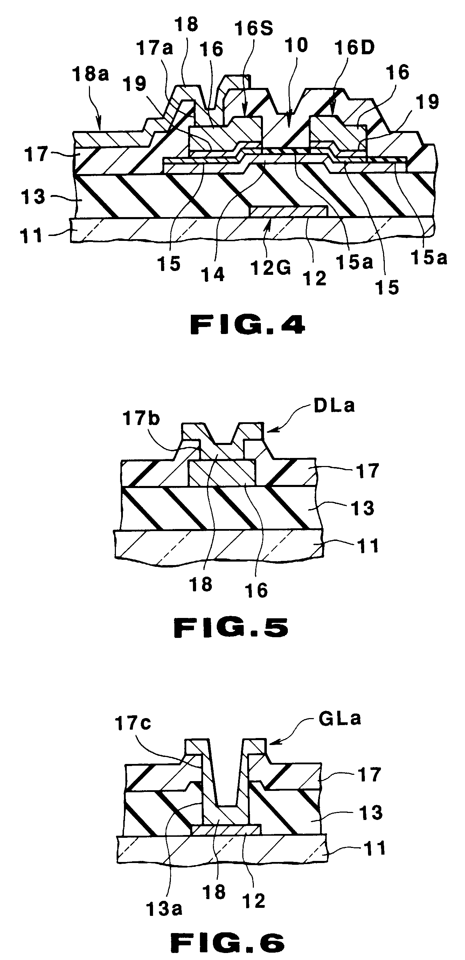

First, the construction of the thin-film transistor will be described. Fig. 3 is a plan view showing a part of a thin-film transistor (TFT) panel which incorporates the thin-film transistor. Figs. 4, 5, and 6 are cross-sectional views of the TFT panel, taken along line IV-IV, line V-V, and line VI-VI shown in Fig. 3, respectively;

The TFT panel comprises a transparent substrate 11 made of glass or the which like, pixel electrodes 18a formed on the substrate 11, and thin-film transistor elements 10 formed on the substrate 11 and functioning as an active elements for the electrodes 18a.

As can be understood from Figs. 3 and 4, the thin-film transistor element 10 comprises a gate electrode 12G formed on the substrate 11, a gate-insulating film 13 covering the gate electrode 12G, an i-type semiconductor layer 14 formed on a portion of the gate-insulating film 13, an n-type semiconductor layer 15 formed on the i-type semiconductor layer 14, a contact layer 19 formed on the n-type semiconductor layer 15, and a source electrode 16S formed on the contact layer 19, and a drain electrode 16D formed on the contact layer 19. The contact layer 19 is made of metal such as Cr.

The gate electrode 12G is integral with a gate line GL formed on the substrate 11. The gate-insulating film 13 covers both the gate electrode 12G and the gate line GL, and is formed on almost the entire surface of the substrate 11. The film 13 is made of SiN or the like. Formed on the gate-insulating film 13 is a data line DL which is connected to the drain electrode 16D. The gate electrode 12G and the gate line GL are formed of a gate metal film 12 which is made of aluminum or an aluminum alloy. The source electrode 16S, the drain electrode 16D, and the data line DL are formed of a drain metal film 16 which is made of aluminum or an aluminum alloy.

The contact layer 19 is divided into two parts, on which the electrode 16S and and 16D are formed, respectively. That part of the layer 19 on which the source electrode 16S is formed has substantially the same shape and size as the source electrode 16S. Similarly, that part of the layer 19 on which the drain electrode 16D is formed has substantially the same shape and size as the source electrode 16D.

The n-type semiconductor layer 15 is formed on the entire surface of the i-type semiconductor layer 14. That portion of this layer 15 which is located below the gap between the source electrode 16S and the drain electrode 16D has been oxidized in its entirety thickness direction and is, therefore, an insulation layer 15a. The peripheral portions of both semiconductor layers 14 and 15 extend outward from the electrodes 16S and 16D. That peripheral portion of the n-type semiconductor layer 15 which extends outward from the drain electrode 16D has been oxidized and is, thus, an insulation layer 15a. Although not shown in Fig. 3 or Fig. 4, that peripheral portion of the n-type semiconductor layer 15 which extends outward from the source electrode 16S has been slightly oxidized.

The pixel electrode 18a is formed on a protective insulation film 17 which is formed on the gate-insulating film 13. The film 17 covers the thin-film transistor element 10, and is made of SiN or the like. The electrode 18a has been formed by patterning a transparent conductive film 18 made of ITO or the like. Its end extends through the contact hole 17a made in the protective insulation film 17 and is thereby electrically connected to the source electrode 16S of the thin-film transistor element 10.

As is shown in Figs. 3 and 5, the terminal portion DLa of the data line DL consists of two layers. The lower layer a metal film 16 and the upper film is a part of the transparent conductive film 18, the remaining part of which is the pixel electrode 18a. The upper film (i.e., the transparent conductive film) 18 is deposited on the lower layer (i.e., the metal film) 16, in the opening 17b which is made in the gate-insulating film 13 and the protective insulation film 17, respectively.

The terminal portion GLa of the gate line GL consists of two layers, too, as is shown in Figs. 3 and 6. The lower layer is a part of the gate metal film 12, and the upper film is a part of the transparent conductive film 18, the remaining part of which is the pixel electrode 18a. The upper film (i.e., the transparent conductive film) 18 is deposited on the lower film (i.e., the gate metal film) 12, in the openings 13a and 17c which are made in the gate-insulating film 13 and the protective insulation film 17, respectively.

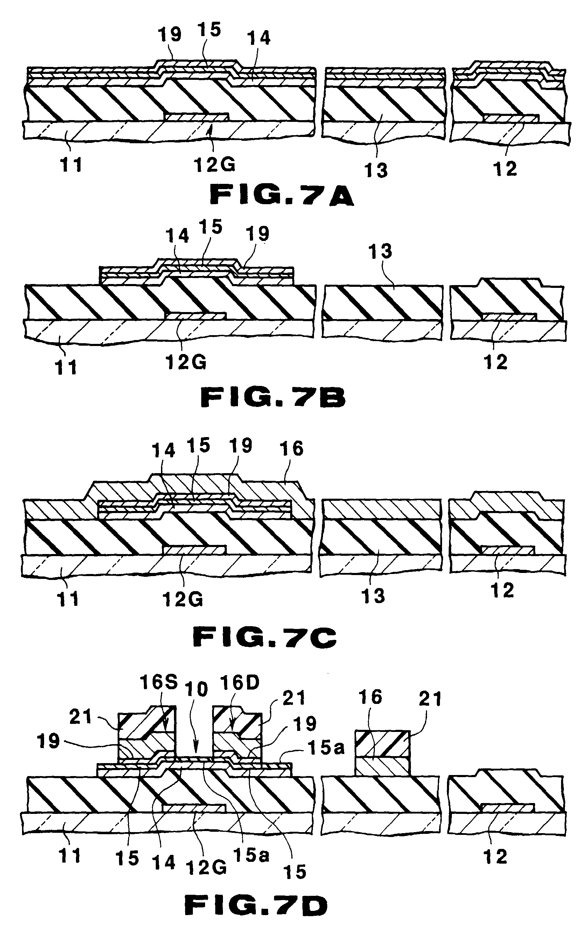

With reference to Figs. 7A to 7D, it will be explained how the thin-film transistor, described above, is manufactured. With reference to Figs. 8A to 8D, it will be explained how the TFT panel incorporating the transistor is manufactured.

Figs. 7A to 7D and Figs. 8A to 8D are cross-sectional views, each showing the thin-film transistor section of the FET panel, the terminal portion of the data line of the thin-film transistor, and the terminal portion of the date line thereof.

### [Step 1]

First, as is shown in Fig. 7A, the gate electrode 12G and the gate line GL are formed on the substrate 11 made of glass or the like. The electrode 12G and the gate line GL are formed by depositing the gate metal film 12 on the substrate 11 and patterning the film 12 by means of photolithography. The metal film 12 shown at the upper-right corner of Fig. 7A is the lower film of the terminal portion GLa of the gate line GL.

### [Step 2]

As is shown in Fig. 7A, too, the gate-insulating film 13 is formed on the substrate 11, covering the gate electrode 12G and the gate line GL. The i-type semiconductor layer 14 is formed on the gate insulating film 13. The n-type semiconductor layer 15 is formed on the i-type semiconductor layer 14. The contact layer 19 is formed on the n-type semiconductor layer.

### [Step 3]

Next, as is shown in Fig. 7B, the contact layer 19, the n-type semiconductor layer 15, and the i-type semiconductor layer 14 are patterned by photolithography, whereby these layers 19, 15, and 14 come to have the shape and size identical to a transistor element region to be formed.

### [Step 4]

As is shown in Fig. 7C, the metal film 16, which will be patterned into the source electrode 16S and the drain electrode 16D, is formed on the substrate 11 and an the gate-insulating film 13, covering the layers 14, 15, and 19 which have been patterned.

### [Step 5]

As is shown in Fig. 7D, the metal film 16 is patterned by photolithography, forming the source electrode 16S, the drain electrode 16D, and the data line DL (see Fig. 4). Then, using the resist mask 21 which has been used in patterning the metal film 16, the contact layer 19 is patterned into two pieces of film which have the same shape and size as the source electrode 16S and the drain electrode 16D, respectively. The metal film 16 shown in the upper-right corner of Fig. 7D is the lower film of the terminal portion DLa of the data line.

### [Step 6]

As shown in Fig. 7D, too, oxidation is performed on the n-type semiconductor layer 15, using the resist mask 21 which has been used in patterning the metal film 16. That portion of the n-type semiconductor layer 15 which extends between the electrodes 16S and 16D is oxidized in its entirety, thickness direction forming an oxidized insulation layer 15a. The insulation layer 15a, thus formed, electrically isolates the two portions of the n-type semiconductor layer 15, on which the source electrode 16S and the drain electrode 16D are respectively formed. Thus is manufactured the thin-film transistor element 10.

The portion of the n-type semiconductor layer 15 may be oxidized in the same way as in the first embodiment.

Through the data line DL and the drain electrode 16D, an electric current is supplied to the n-type semiconductor layer 15 during the anodic oxidation of said portion of the layer 15. Hence, the n-type semiconductor layers 15 of all thin-film transistor elements (in this figure only one element is shown) which are arranged along the data line DL can be anodically oxidized uniformly. Since the resist mask 21 does not cover neither the sides of the drain electrode 16D nor the sides of the data line DL, the sides of both the electrode 16D and those of the data line DL are oxidized anodically. (The resultant oxide layers are not shown.) Nonetheless, the center portion of the electrode 16D or the center portion of the data line DL is not oxidized at all. Therefore, both the drain electrode 16D and the data line DL maintain as electrically conductive as is desired.

The i-type semiconductor layer 14 and the n-type semiconductor layer 15 extend outward from the peripheries of the electrodes 16S and 16D -- that is, from the periphery of the resist mask 21. Hence, that portions of the layer 15 which extend from the periphery of the drain electrode 16D are oxidized, forming the insulation layers 15a. Also, the surface of that portion of the layer 15 which extends from the source electrode 16S, and the sides of the source electrode 16S are slightly oxidized, though not shown in Figs. 7A to 7D.

The resistivity which the i-type semiconductor layer 14 has when no voltage is applied to the gate electrode 15G is 100 or more times greater than the resistivity of the n-type semiconductor layer 15. Therefore, the i-type semiconductor layer 14, located below the layer 15, is not oxidized at all when the n-type semiconductor layer 15 is oxidized anodically.

The TFT panel is manufactured as will be explained below, after a number of thin-film transistors elements 10 have been formed as has been described above.

### [Step 7]

The resist mask 21 is removed. As is shown in Fig. 8A, the protective insulation film 17 is formed on the gate-insulating film 13, thus covering the thin-film transistor elements 10.

### [Step 8]

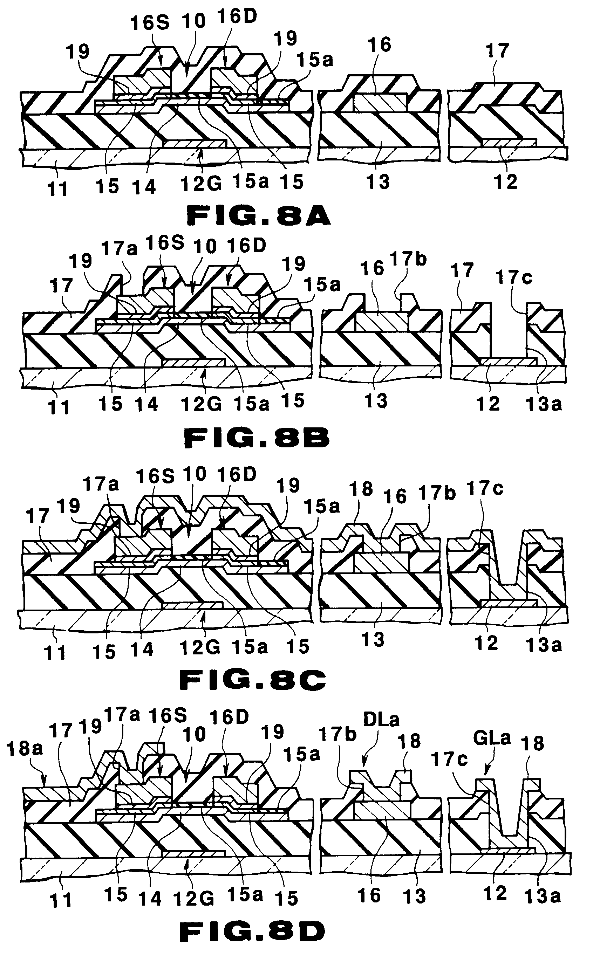

Next, as can be understood from Fig. 8B, the protective insulation film 17 is patterned by means of photolithography, making a contact hole 17a, an opening 17b, and an opening 17c. The hole 17a exposes the source electrode 16S of the transistor element 10; the opening 17b exposes that portion of the metal film 16 which will be connected to the terminal portion DLa of the data line DL; and the opening 17c exposes the gate-insulating film 13. An opening 13a aligned with the opening 17c is formed in the gate-insulating film 13, thus exposing that portion of the metal film 12 which will be connected to the terminal portion GLa of the gate line GL.

Then, as is shown in Fig. 8C, the transparent conductive film 18 made of ITO or the like is formed on the protective insulation film 17, also in the contact holes 17a and the openings 17b and 17c, all made in the film 17, and also in the opening 13a made in the gate-insulating film 13. Therefore, the film 18 is formed on the source electrode 16S of the thin-film transistor element 10, and on the lower films 16 and 12 of the terminal portion DLa of the data line DL, and of the terminal portion GLa of the gate line GL (i.e., the metal films 16 and 12).

Further, as is shown in Fig. 8D, the transparent conductive film 18 is patterned by photolithography, forming the pixel electrode 18a, the upper film of the terminal portion DLa of the data line DL, and the upper film of the terminal portion GLa of the gate line GL. As a result, the TFT panel is manufactured.

## Claims

1. A thin film-transistor panel,
the transistor of which are formed on an insulating substrate (11) and include a source electrode (16S), a drain electrode (16D) and
a gate electrode (12G) ;
the panel further comprising
a gate line (GL) connected to the gate electrode (12G);
a gate-insulating film (13) covering the gate electrode (12G) and the gate line (GL);
an i-type semiconductor film (14) to face the gate electrode (12G) through the insulating film (13) therebetween;
a first n-type semiconductor film (15) formed on a source region of the i-type semiconductor film (14);
a second n-type semiconductor film (15) formed on a drain region of the i-type semiconductor film (14);
the source electrode (16S) being electrically connected to the source region of the i-type semiconductor film (14) through the first n-type semiconductor film (15);
the drain electrode (16D) being electrically connected to the drain region of the i-type semiconductor film (14) through the second n-type semiconductor film (15);
a drain line (DL) connected to the drain electrode (16D);
an insulating film (15a) located between the source and drain electrodes to electrically isolate said source and drain electrodes;
a pixel electrode (18a) formed of transparent conductive material and formed on and electrically connected to said source electrode (16S);
a gate connection terminal (GLa) connected to the gate line (GL); and
a drain connection terminal (DLa) connected to the drain line (DL);
characterized in that
the gate connection terminal (GLa) has a lower film (12) of metal and an upper film (18) of transparent conductive material preventing the lower film (12) from being exposed to the atmosphere; and
the drain connect on terminal (DLa) has a lower film (16) of metal and an upper film (13) of transparent conductive material preventing the lower film (16) from being exposed to the atmosphere.

2. A thin-film transistor panel according to claim 1, characterized in that the transparent conductive material is formed of ITO.

3. A thin-film transistor panel according to claim 1 or 2 characterized by further comprising a protective insulating film (17) covering said thin-film transistor element (10) and having a first opening (17a) located on said source electrode (16S), a second opening (17b) located on the drain connection terminal (DLa) and a third opening (17c) located on the gate connection terminal (GLa), and
said pixel electrode (18a) being formed on the protective film (17) and connected to the source electrode (16S) through the first opening, the upper film of the drain connection terminal (DLa) extending through the second opening (17b), and the upper film (18) of the gate connection terminal (GLa) extending through the third opening (17c).

4. A thin film transistor panel according to at least one of at least claims 1 to 3, characterized in that the insulating film (15a) is formed of an oxidized n-type semiconductor film (15).

5. A thin-film transistor panel according to at least one of claims 1 to 4 characterized by further comprising a first contact film (19) formed between the source electrode (16S) and the first n-type semiconductor film (15), and a second contact film (19) formed between the drain electrode (16D) and the second n-type semiconductor film (15).

6. A method of manufacturing a thin-film transistor panel having TFT elements arranged in a matrix form comprising the steps of:
forming a TFT element having a gate electrode (12G), a gate line (GL) connected to the gate electrode (12G) and having a metal film (12), a gate-insulating film (13) formed on the gate electrode (12G) and the gate line (GL), an i-type semiconductor film (14) formed on the gate-insulating film (13), a source electrode (16S) connected to a source region of the i-type semiconductor film (14) through an n-type semiconductor film (15), a drain electrode (16D) connected to a drain region of the i-type semiconductor film (14) through said n-type semiconductor film (15), and insulating film (15a) formed on a channel region of the i-type semiconductor film, and a drain line (DL) connected to the drain electrode (16D) and a metal film (16), and
forming a pixel electrode (18a) made of a transparent conductive film (18) on the TFT element
characterized in that
the pixel electrode forming step includes the steps of forming a transparent conductive film (13) on the TFT element (10) and the metal films (12,16) and patterning the transparent conductive film (18) so as to form the pixel electrode (13a) connected to the source electrode (16S) and to form connection terminals (DLa,GLa) formed on the metal films (12,16) of the drain and gate lines (DL,GL).

7. The method according to claim 5, characterized by further comprising a step of forming a contact film (19) on the n-type semiconductor film (14), and in that the step of patterning the n-type semiconductor films also patterns the contact film (19) into the element shape.

## Patentansprüche

1. Dünnschicht-Transistorplatte, deren Transistoren auf einem isolierenden Substrat (11) gebildet sind und eine Sourceelektrode (16S), eine Drainelektrode (16D) und eine Gateelektrode (12G) einschließen, wobei die Platte weiter umfaßt:
eine Gateleitung (GL), die mit der Gateelektrode (12G) verbunden ist;
einen Gate-Isolierfilm (13), der die Gateelektrode (12G) und die Gateleitung (GL) bedeckt;
einen I-Typ-Halbleiterfilm (14), der der Gateelektrode (12G) über den Isolierfilm (13) dazwischen gegenüberliegt;
einen ersten N-Typ-Halbleiterfilm (15), der auf einer Sourcezone des I-Typ-Halbleiterfilms (14) gebildet ist;
einen zweiten N-Typ-Halbleiterfilm (15), der auf einer Drainzone des I-Typ-Halbleiterfilms (14) gebildet ist,
wobei die Sourceelektrode (16S) über den ersten N-Typ-Halbleiterfilm (15) mit der Sourcezone des I-Typ-Halbleiterfilms (14) elektrisch verbunden ist,
wobei die Drainelektrode (16D) über den zweiten N-Typ-Halbleiterfilm (15) mit der Drainzone des I-Typ-Halbleiterfilms (14) elektrisch verbunden ist,
eine Drainleitung (DL), die mit der Drainelektrode (16D) verbunden ist;
einen Isolierfilm (15a), der zwischen der Source- und der Drainelektrode gelegen ist und die Source- und die Drainelektrode elektrisch isoliert;
eine Pixelelektrode (18a), die aus durchsichtigem leitfähigen Material gebildet ist und auf der Sourceelektrode (16S) gebildet und damit elektrisch verbunden ist;
einen Gate-Verbindungsanschluß (GLa), der mit der Gateleitung (GL) verbunden ist, und
einen Drain-Verbindungsanschluß (DLa), der mit der Drainleitung (DL) verbunden ist,
dadurch gekennzeichnet, daß
der Gate-Verbindungsanschluß (GLa) einen unteren Film (12) aus Metall und einen oberen Film (18) aus durchsichtigem leitfähigen Material aufweist, der verhindert, daß der untere Film (12) der Atmosphäre ausgesetzt wird, und
der Drain-Verbindungsanschluß (DLa) einen unteren Film (16) aus Metall und einen oberen Film (18) aus durchsichtigem leitfähigen Material aufweist, der verhindert, daß der untere Film (16) der Atmosphäre ausgesetzt wird.

2. Dünnschicht-Transistorplatte nach Anspruch 1, dadurch gekennzeichnet, daß das durchsichtige leitfähige Material aus ITO gebildet ist.

3. Dünnschicht-Transistorplatte nach Anspruch 1 oder 2, dadurch gekennzeichnet, daß sie weiter einen Schutzisolierfilm (17) umfaßt, der das Dünnschicht-Transistorelement (10) bedeckt und eine erste Öffnung (17a), die auf der Sourceelektrode (16S) gelegen ist, eine zweite Öffnung (17b), die auf dem Drain-Verbindungsanschluß (DLa) gelegen ist, und eine dritte Öffnung (17c) aufweist, die auf dem Gate-Verbindungsanschluß (GLa) gelegen ist, und
wobei die Pixelelektrode (18A) auf dem Schutzfilm (17) gebildet und durch die erste Öffnung mit der Sourceelektrode (16S) verbunden ist, der obere Film des Drain-Verbindungsanschlusses (DLa) sich durch die zweite Öffnung (17b) erstreckt und der obere Film (18) des Gate-Verbindungsanschlusses (GLa) sich durch die dritte Öffnung (17c) erstreckt.

4. Dünnschicht-Transistorplatte nach einem der Ansprüche 1 bis 3, dadurch gekennzeichnet, daß der Isolierfilm (15a) aus einem oxidierten N-Typ-Halbleiterfilm (15) gebildet ist.

5. Dünnschicht-Transistorplatte nach einem der Ansprüche 1 bis 4, dadurch gekennzeichnet, daß sie weiter einen ersten zwischen der Sourceelektrode (16S) und dem ersten N-Typ-Halbleiterfilm (15) gebildeten Kontaktfilm (19), und einen zweiten zwischen der Drainelektrode (16D) und dem zweiten N-Typ-Halbleiterfilm (15) gebildeten Kontaktfilm (19) umfaßt.

6. Verfahren zur Herstellung einer Dünnschicht-Transistorplatte mit in einer Matrixform angeordneten TFT-Elementen, das die Schritte umfaßt:
Bilden eines TFT-Elements mit einer Gateelektrode (12G), einer Gateleitung (GL), die mit der Gateelektrode (12G) verbunden ist und einen Metallfilm (12) aufweist, einem Gate-Isolierfilm (13), der auf der Gateelektrode (12G) und der Gateleitung (GL) gebildet ist, einem I-Typ-Halbleiterfilm (14), der auf dem Gate-Isolierfilm (13) gebildet ist, einer Sourceelektrode (16S), die über einen N-Typ-Halbleiterfilm (15) mit einer Sourcezone des I-Typ-Halbleiterfilms (14) verbunden ist, einer Drainelektrode (16D), die über den N-Typ-Halbleiterfilm (15) mit einer Drainzone des I-Typ-Halbleiterfilms (14) verbunden ist, einem Isolierfilm (15a), der auf einer Kanalzone des I-Typ-Halbleiterfilms (14) gebildet ist, und einer Drainleitung (DL), die mit der Drainelektrode (16D) verbunden ist und einen Metallfilm (16) besitzt, und
Bilden einer aus einem durchsichtigen leitfähigen Film (18) bestehenden Pixelelektrode (18a) auf dem TFT-Element
dadurch gekennzeichnet, daß
der Pixelelektroden-Bildungsschritt die Schritte zum Bilden eines durchsichtigen leitfähigen Films (18) auf dem TFT-Element (10) und den Metallfilmen (12, 16) und Mustern des durchsichtigen leitfähigen Films (18) umfaßt, um die mit der Sourceelektrode (16S) verbundene Pixelelektrode (18a) und auf den Metallfilmen (12, 16) der Drain- und Gateleitungen (DL, GL) gebildete Verbindungsanschlüsse (DLa, GLa) zu bilden.

7. Verfahren nach Anspruch 6, dadurch gekennzeichnet, daß es weiter einen Schritt zum Bilden eines Kontaktfilms (19) auf dem N-Typ-Halbleiterfilm (15) umfaßt und dadurch, daß der Schritt, der die N-Typhalbleiterfilme mustert, auch den Kontaktfilm (19) in die Elementform mustert.

## Revendications

1. Panneau de transistors à couches minces dont les transistors sont formés sur un substrat isolant (11) et comprennent une électrode de source (16S), une électrode de drain (16D) et une électrode de grille (12G),
le panneau comprenant en outre:
- une ligne de grille (GL) connectée à l'électrode de grille (12G);
- une couche isolante de grille (13) recouvrant l'électrode de grille (12G) et la ligne de grille (GL);
- une couche de semiconductuer du type I (14) faisant face à l'électrode de grille (12G) à travers la couche isolante (13) disposée entre deux;
- une première couche de semiconducteur du type N (15) formée sur une région de source de la couche de semiconducteur du type I (14);
- une deuxième couche de semiconducteur du type N (15) formée sur une région de drain de la couche de semiconducteur du type I (14),
l'électrode de source (16S) étant connectée électriquement à la région de source de la couche de semiconducteur du type I (14) à travers la première couche de semiconducteur du type N (15), et
l'électrode de drain (16D) étant connectée électriquement à la région de drain de la couche de semiconducteur du type I (14) à travers la deuxième couche de semiconducteur du type N (15);
- une ligne de drain (DL) connectée à l'électrode de drain (16D);
- une couche isolante (15a) située entre les électrodes de source et de drain pour isoler électriquement lesdites électrodes de source et de drain;
- une électrode d'élément d'image (18a) constituée d'une matière conductrice transparente et formée sur ladite électrode de source (16S) et connectée à celle-ci;
- une borne de connexion de grille (GLa) connectée à la ligne de grille (GL); et
- une borne de connexion de drain (DLa) connectée à la ligne de drain (DL),
caractérisé en ce que:
- la borne de connexion de grille (GLa) a une couche inférieure (12) de métal et une couche supérieure (18) de matière conductrice transparente empêchant la couche inférieure (12) d'être exposée à l'atmosphère; et
- la borne de connexion de drain (DLa) a une couche inférieure (16) de métal et une couche supérieure (18) de matière conductrice transparente empêchant la couche inférieure (16) d'être exposée à l'atmosphère.

2. Panneau de transistors à couches minces selon la revendication 1, caractérisé en ce que la matière conductrice transparente est constituée d'oxyde d'étain dopé à l'indium (ITO).

3. Panneau de transistors à couches minces selon la revendication 1 ou 2, caractérisé en ce qu'il comprend en outre une couche isolante de protection (17) recouvrant ledit élément à transistor à couches minces (10) et ayant une première ouverture (17a) située sur ladite électrode de source (16S), une deuxième ouverture (17b) située sur la borne de connexion de drain (DLa) et une troisième ouverture (17c) située sur la borne de connexion de grille (GLa); et
- ladite électrode d'élément d'image (18a) étant formée sur la couche de protection (17) et connectée à l'électrode de source (16S) dans la première ouverture, la couche supérieure de la borne de connexion de drain (DLa) s'étendant dans la deuxième ouverture (17b), et la couche supérieure (18) de la borne de connexion de grille (GLa) s'étendant dans la troisième ouverture (17c).

4. Panneau de transistors à couches minces selon au moins une des revendications 1 à 3, caractérisé en ce que la couche isolante (15a) est constituée par une couche oxydée de semiconducteur du type N (15).

5. Panneau de transistors à couches minces selon au moins une des revendications 1 à 4, caractérisé en ce qu'il comprend en outre une première couche de contact (19) formée entre l'électrode de source (16S) et la première couche de semiconducteur du type N (15) , et une deuxième couche de contact (19) formée entre l'électrode de drain (16D) et la deuxième couche de semiconducteur du type N (15).

6. Procédé de fabrication d'un panneau de transistors à couches minces ayant des éléments à transistor à couches minces disposés sous la forme d'une matrice, le procédé comprenant les étapes consistant à:
- former un élément à transistor à couche mince ayant une électrode de grille (12G), une ligne de grille (GL) connectée à l'électrode de grille (12G) et ayant une couche métallique (12), une couche isolante de grille (13) formée sur l'électrode de grille (12G) et la ligne de grille (GL), une couche de semiconducteur du type I (14) formée sur la couche isolante de grille (13), une électrode de source (16S) connectée à une région de source de la couche de semiconducteur du type I (14) à travers une couche de semiconducteur du type N (15), une électrode de drain (16D) connectée à une région de drain de la couche de semiconducteur du type I (14) à travers ladite couche de semiconducteur du type N (15), et une couche isolante (15a) formée sur une région de canal de la couche de semiconducteur du type I, et une ligne de drain (DL) connectée à l'électrode de drain (16D), et une couche métallique (16), et
- former une électrode d'élément d'image (18a) constituée par une couche conductrice transparente (18) sur l'élément à transistor à couches minces,
caractérisé en ce que:
- l'étape de formation de l'électrode d'élément d'image comprend les étapes consistant à former une couche conductrice transparente (18) sur l'élément à transistor à couches minces (10) et les couches métalliques (12, 16), et à mettre en forme de motif la couche conductrice transparente (18) de manière à former l'électrode d'élément d'image (18a) connectée à l'électrode de source (16S) et à former des bornes de connexion (DLa, GLa) formées sur les couches métalliques (12, 16) des lignes de drain et de grille (DL, GL).

7. Procédé selon la revendication 6, caractérisé en ce qu'il comprend une étape consistant à former une couche de contact (19) sur la couche de semiconducteur du type N (14), et en ce que l'étape de mise en forme de motif des couches de semiconducteur du type N met également la couche de contact (19) à la forme de l'élément.
